# EUROPEAN PATENT APPLICATION

(11) **EP 3 643 752 A1**
(43) Date of publication of application: **29.04.2020**
(21) Application number: 18820169.3
(22) Date of filing: 22.06.2018
(51) Int. Cl.: C08L 101/00, H01F 1/375, H05K 9/00

(54) **ELECTROMAGNETIC WAVE ABSORBING COMPOSITION AND ELECTROMAGNETIC WAVE ABSORPTION SHEET**

(30) Priority: 23.06.2017 JP 2017123462
(71) Applicant: Maxell Holdings, Ltd., Otokuni-gun, Kyoto 618-8525 (JP)
(72) Inventor: FUJITA, Masao, Otokuni-gun, Kyoto 618-8525 (JP); HIROI, Toshio, Otokuni-gun, Kyoto 618-8525 (JP)
(74) Representative: Diehl & Partner GbR
(86) International application number: PCT/JP2018/023865
(87) International publication number: WO 2018/235952

(57) **Abstract**

Provided is an electromagnetic-wave absorbing composition that can favorably absorb electromagnetic waves of high frequencies in or above the millimeter-wave band, that can produce a sufficiently flexible and elastic electromagnetic-wave absorbing sheet, and that can be used also as an electromagnetic-wave absorbing coating material. The electromagnetic-wave absorbing composition includes: magnetic iron oxide powder 1a having a magnetic resonance frequency; a binder resin 1b; and a dispersant. The dispersant has an acid number of 8 mg KOH/g or more and 46 mg KOH/g or less and an amine number of 18 mg KOH/g or more and 44 mg KOH/g or less. The electromagnetic-wave absorbing sheet is produced using the electromagnetic-wave absorbing composition.

## Description

### Technical Field

The present disclosure relates to an electromagnetic-wave absorbing composition that has electromagnetic-wave absorbing properties, and in particular relates to an electromagnetic-wave absorbing composition that includes magnetic iron oxide powder as an electromagnetic-wave absorbing material to absorb electromagnetic waves of high frequencies in or above a millimeter-wave band, and an electromagnetic-wave absorbing sheet that includes the electromagnetic-wave absorbing composition as an electromagnetic-wave absorbing layer.

### Background Art

Electromagnetic-wave absorbing compositions that absorb electromagnetic waves have been used to avoid the influence of leaked electromagnetic waves emitted to the outside from an electric circuit or the like and the influence of undesirably reflected electromagnetic waves. The electromagnetic-wave absorbing compositions are formed into predetermined shapes as electromagnetic-wave absorbing members such as electromagnetic-wave absorbers in the form of a block and electromagnetic-wave absorbing sheets in the form of a sheet, and also known for use as electromagnetic-wave absorbing coating materials that are applied to desired locations.

Recently, research on technology utilizing high frequency electromagnetic waves, including centimeter waves having frequencies of several gigahertz (GHz), millimeter waves having frequencies of 30 GHz to 300 GHz, and electromagnetic waves having even higher frequencies of one terahertz (THz) as electromagnetic waves in a high frequency band above the millimeter-wave band, has advanced in mobile communication such as mobile phones, wireless LANs, and electric toll collection systems (ETC).

In response to the technological trend of utilizing electromagnetic waves of higher frequencies, there is growing demand for electromagnetic-wave absorbers, electromagnetic-wave absorbing sheets and electromagnetic-wave absorbing coating materials for absorbing unnecessary electromagnetic waves to absorb electromagnetic waves in higher frequency bands from the gigahertz band to the terahertz band.

As electromagnetic-wave absorbers for absorbing electromagnetic waves in a high frequency band in or above the millimeter-wave band, Patent Document 1 proposes an electromagnetic-wave absorber that has a packed structure of particles having epsilon iron oxide (ε-Fe₂O₃) crystal in the magnetic phase, the epsilon iron oxide exhibiting an electromagnetic-wave absorbing capacity in a range from 25 to 100 GHz (see Patent Document 1). Patent Document 2 proposes a sheet-shaped oriented body obtained by mixing and kneading fine epsilon iron oxide particles with a binder, and applying a magnetic field to the mixture from the outside during dry curing of the binder to improve the magnetic field orientation of the epsilon iron oxide particles (see Patent Document 2).

Patent Document 3 proposes an elastic electromagnetic-wave absorbing sheet in which carbon nanotubes are dispersed in silicone rubber (see Patent Document 3). Patent Document 4 proposes an electromagnetic-wave absorbing coating material having a heat resistance of 300°C or higher, which can be used at a high temperature area such as around an engine exhaust port, by using an alkali metal silicate-based water glass as a binder (see Patent Document 4).

Patent Document 5 proposes an ink composition for an electromagnetic-wave absorber, including: an organic metal complex having a magnetic spin such as Co (cobalt) or Fe (iron) as an rare earth ion-containing clathrate (electromagnetic-wave absorbing fine particles); a polymer type wet dispersant having an acid number of 8-20 and an amine number of 20-32 (dispersant); and a resin binder (see Patent Document 5). Patent Document 6 proposes a paste composition for an electronic material including an inorganic oxide such as a black pigment that contains a water-soluble dispersant having an amine number of 20 mg KOH/g or more and an acid number of 30 mg KOH /g or more (see Patent Document 6).

### Prior Art Documents

### Patent Documents

Patent Document 1: JP 2008-060484 A
Patent Document 2: JP 2016-135737 A
Patent Document 3: JP 2011-233834 A
Patent Document 4: JP 2016-098243 A
Patent Document 5: JP 2002-188031 A
Patent Document 6: JP 2009-149745 A

### Disclosure of Invention

### Problem to be solved by the Invention

To shield electromagnetic waves leaking from an electromagnetic-wave generation source, it is necessary to arrange an electromagnetic-wave absorbing material in a housing or the like that covers a target circuit component. In particular, when the shape of the arrangement location is not flat, it is more convenient and preferable to use an electromagnetic-wave absorbing sheet having flexibility, rather than using a bulky electromagnetic-wave absorber. Further, to cover a wide area such as a wall surface or the entire surface of equipment with a complicated shape, it is advantageous to use an electromagnetic-wave absorbing coating material that exhibits electromagnetic-wave absorbing properties when applied.

However, the frequencies of electromagnetic waves that can be absorbed by the conventional electromagnetic-wave absorbing sheet described in Patent Document 3 are frequencies in the centimeter-wave band, and the frequencies of electromagnetic waves that can be absorbed by the electromagnetic-wave absorbing coating material described in Patent Document 4 remain around 10 GHz. Further, the paste compositions described in Patent Documents 5 and 6 are not configured to absorb electromagnetic waves of high frequencies in or above the millimeter-wave band.

As described above, as electromagnetic-wave absorbing compositions that can absorb electromagnetic waves of frequencies of several tens of GHz or higher (i.e., electromagnetic waves in or above the millimeter-wave band), sufficiently flexible and elastic electromagnetic-wave absorbing sheets or electromagnetic-wave absorbing coating materials that can be applied to desired locations have not yet been realized.

In order to solve the conventional problems, it is an object of the present disclosure to provide an electromagnetic-wave absorbing composition that can favorably absorb electromagnetic waves of high frequencies in or above the millimeter-wave band, that can produce a sufficiently flexible and elastic electromagnetic-wave absorbing sheet, and that can be used also as an electromagnetic-wave absorbing coating material.

### Means for Solving Problem

To solve the above problem, an electromagnetic-wave absorbing composition disclosed in the present application includes: magnetic iron oxide powder having a magnetic resonance frequency; a binder resin; and a dispersant. The dispersant has an acid number of 8 mg KOH/g or more and 46 mg KOH/g or less and an amine number of 18 mg KOH/g or more and 44 mg KOH/g or less.

### Effects of the Invention

The electromagnetic-wave absorbing composition disclosed in the present application includes: magnetic iron oxide powder having a magnetic resonance frequency that can absorb electromagnetic waves of high frequencies in the millimeter-wave band through magnetic resonance (electromagnetic-wave absorbing material); a resin binder; and a dispersant having an acid number of 8 mg KOH/g or more and 46 mg KOH/g or less and an amine number of 18 mg KOH/g or more and 44 mg KOH/g or less. With this, the fine magnetic iron oxide powder can be favorably dispersed in the binder, and thus a flexible and elastic electromagnetic-wave absorbing sheet and an electromagnetic-wave absorbing composition that can be used also as an electromagnetic-wave absorbing coating material can be obtained.

### Brief Description of Drawings

[FIG. 1] FIG. 1 is a cross-sectional view illustrating the configuration of an electromagnetic-wave absorbing sheet formed using an electromagnetic-wave absorbing composition of an embodiment.
[FIG. 2] FIG. 2A and FIG. 2B are conceptual illustrations for explaining the function of a dispersant in the electromagnetic-wave absorbing composition of this embodiment.
[FIG. 3] FIG. 3 is a view illustrating a method for measuring the flexibility of an electromagnetic-wave absorbing sheet of this embodiment.
[FIG. 4] FIG. 4 is a graph illustrating measurement results of a tensile test, indicating the elasticity of the electromagnetic-wave absorbing sheet of this embodiment.
[FIG. 5] FIG. 5 is a graph indicating the storage stability of the electromagnetic-wave absorbing composition of this embodiment.

### Description of the Invention

The electromagnetic-wave absorbing composition disclosed in the present application includes: magnetic iron oxide powder having a magnetic resonance frequency; a binder resin; and a dispersant. The dispersant has an acid number of 8 mg KOH/g or more and 46 mg KOH/g or less and an amine number of 18 mg KOH/g or more and 44 mg KOH/g or less.

By doing so, in the electromagnetic-wave absorbing composition disclosed in the present application, the magnetic iron oxide powder having a magnetic resonance frequency as the electromagnetic-wave absorbing material can be favorably dispersed in the binder. Thus, the electromagnetic-wave absorbing composition can form a highly flexible and elastic sheet while capable of being stored as a solution for a long period of time.

In the electromagnetic-wave absorbing composition disclosed in the present application, it is preferred that a glass transition temperature (Tg) of the binder resin is -10°C to -40°C. By doing so, an electromagnetic-wave absorbing sheet formed therefrom can have favorable flexibility and elasticity.

It is preferred that the magnetic iron oxide powder is at least one of epsilon iron oxide and strontium ferrite. By doing so, it is possible to obtain an electromagnetic-wave absorbing composition utilizing the high electromagnetic-wave absorbing capacity of the epsilon iron oxide or strontium ferrite.

In this case, it is preferred that part of a Fe site of the epsilon iron oxide is substituted with a trivalent metal atom. By doing so, it is possible to easily obtain an electromagnetic-wave absorbing composition that can absorb electromagnetic waves in a desired frequency band.

Further, by forming an electromagnetic-wave absorbing layer from any of the electromagnetic-wave absorbing compositions according to the present application, it is possible to realize a highly flexible and elastic electromagnetic-wave absorbing sheet.

Hereinafter, the electromagnetic-wave absorbing composition and electromagnetic-wave absorbing sheet disclosed in the present application will be described with reference to the drawings.

### (Embodiment)

### [Electromagnetic-wave absorbing sheet]

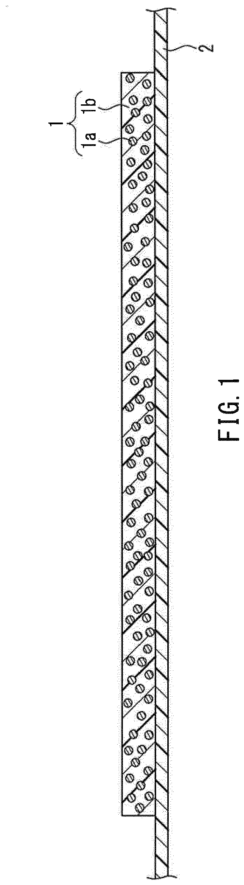

FIG. 1 is a cross-sectional view illustrating the configuration of an electromagnetic-wave absorbing sheet formed using an electromagnetic-wave absorbing composition of this embodiment.

FIG. 1 illustrates a state in which an electromagnetic-wave absorbing sheet 1 is formed on a resin sheet 2 (base) by applying an electromagnetic-wave absorbing composition to the resin sheet 2 and drying it.

FIG. 1 is illustrated for the sake of easy understanding of the configuration of the electromagnetic-wave absorbing sheet of this embodiment, and does not faithfully reflect the actual sizes or thicknesses of members illustrated therein.

The electromagnetic-wave absorbing sheet 1 exemplified in this embodiment includes magnetic iron oxide powder 1a (electromagnetic-wave absorbing material in the form of particles) having a magnetic resonance frequency and a resin binder 1b. The electromagnetic-wave absorbing sheet 1 also includes a dispersant to disperse the magnetic iron oxide powder 1a favorably in the resin binder 1b. The dispersant is inclusively illustrated in the resin binder 1b.

In the electromagnetic-wave absorbing sheet 1 of this embodiment, powder of epsilon iron oxide as the magnetic iron oxide powder 1a resonates magnetically, and converts electromagnetic waves into heat energy through magnetic loss to dissipate them. Because of this, the electromagnetic-wave absorbing sheet 1 of this embodiment can absorb electromagnetic waves by itself and can be used as a transmission-type electromagnetic-wave absorbing sheet, which does not include a reflective layer on the back surface.

### [Electromagnetic-wave absorbing material]

In the electromagnetic-wave absorbing sheet of this embodiment, epsilon iron oxide magnetic powder is used as the magnetic iron oxide powder having a magnetic resonance frequency.

The epsilon phase of epsilon iron oxide (ε-Fe₂O₃) is a phase that appears between the alpha phase (α-Fe₂O₃) and the gamma phase (γ-Fe₂O₃) in ferric oxide (Fe₂O₃). Epsilon iron oxide is a magnetic material that can be obtained in a single phase state through a nanoparticle synthesis method that combines a reverse micelle method and a sol-gel method.

Epsilon iron oxide is a fine particle of several nm to several tens of nm but has a coercive force of about 20 kOe at room temperature, which is the largest coercive force among metal oxides. Further, since the natural magnetic resonance by a gyromagnetic effect based on the precession occurs in a frequency band of several tens of GHz or higher (millimeter-wave band), epsilon iron oxide has a high effect of absorbing electromagnetic waves with frequencies of 30 to 300 GHz (millimeter-wave band) or even higher.

In epsilon iron oxide, by substituting part of the Fe site of the crystal with a trivalent metal element such as aluminum (Al), gallium (Ga), rhodium (Rh) or indium (In), it is possible to change a magnetic resonance frequency, i.e., a frequency of electromagnetic waves to be absorbed when epsilon iron oxide is used as the electromagnetic-wave absorbing material.

For example, epsilon iron oxide substituted with gallium (ε-GaₓFe₂₋ₓO₃) has an absorption peak in a frequency band from about 30 GHz to 150 GHz as a result of adjusting the substitution amount "x". Epsilon iron oxide substituted with aluminum (ε-AlₓFe₂₋ₓO₃) has an absorption peak in a frequency band from about 100 GHz to 190 GHz as a result of adjusting the substitution amount "x". Further, in the case of using epsilon iron oxide substituted with rhodium (ε-RhₓFe₂₋ₓO₃), it is possible to shift the frequency band of electromagnetic waves to be absorbed in an even higher direction of 180 GHz or higher. Thus, the frequency of electromagnetic waves to be absorbed can be set to a desired value by selecting the type of the element with which the Fe site of the epsilon iron oxide is substituted and adjusting the substitution amount of Fe so that the natural resonance frequency of the epsilon iron oxide will be a desired frequency to be absorbed by the electromagnetic-wave absorbing sheet.

Epsilon iron oxides, including epsilon iron oxides in which part of the Fe site is substituted with metal, can be obtained easily on the market.

Examples of the magnetic iron oxide powder as the electromagnetic-wave absorbing material having a magnetic resonance frequency, which is used in the electromagnetic-wave absorbing composition of this embodiment, include barium ferrite magnetic powder and strontium ferrite magnetic powder, in addition to the epsilon iron oxide powder. With this, it is possible to provide an electromagnetic-wave absorbing composition that absorbs electromagnetic waves in high frequency bands such as the GHz band and the millimeter-wave band, and an electromagnetic-wave absorbing sheet produced using the composition.

It is preferred that magnetoplumbite strontium ferrite magnetic powder is used as the strontium ferrite. Specifically, when magnetoplumbite strontium ferrite magnetic powder expressed by compositional formula SrFe₍₁₂₋ₓ₎AlₓO₁₉ (x: 1.0 to 2.2) is used, electromagnetic waves can be effectively absorbed in the band of 76 GHz ± 10 GHz. As the size (particle diameter) of strontium ferrite, magnetic powder with a peak particle diameter in a laser diffraction/scattering particle size distribution of 1 µm or more, and preferably magnetic powder with a peak particle diameter in a laser diffraction/scattering particle size distribution of 10 µm or more can be used, particularly from the viewpoint of the electromagnetic-wave absorbing properties.

### [Resin binder]

As the resin binder in the electromagnetic-wave absorbing composition of this embodiment, a resin material such as epoxy resin, polyester resin, polyurethane resin, acrylic resin, phenol resin, melamine resin, or rubber resin can be used.

More specifically, examples of the epoxy resin include a compound obtained by epoxidation of hydroxyl groups at both ends of bisphenol A. Examples of the polyurethane resin include polyester urethane resin, polyether urethane resin, polycarbonate urethane resin, and epoxy urethane resin. Examples of the acrylic resin include a functional group-containing methacrylic polymer obtained by copolymerization of alkyl acrylate and/or alkyl methacrylate, both of which are methacrylic resin having an alkyl group with 2 to 18 carbon atoms, and a functional group-containing monomer, and optionally other modifying monomers copolymerizable with them.

Examples of the rubber resin used as a binder include: styrene-based thermoplastic elastomers such as SIS (styrene-isoprene block copolymer) and SBS (styrene-butadiene block copolymer); petroleum synthetic rubber such as EPDM (ethylene-propylene-diene-rubber); and other rubber materials such as acrylic rubber and silicone rubber.

Among these various resins, the polyester resins are preferred as the binder, from the viewpoint of dispersion after blending resin, to form a highly flexible electromagnetic-wave absorbing sheet.

Among these various resin binders, those having a glass transition temperature (Tg) of -10°C to -40°C are preferred. Resin binders having a glass transition temperature lower than -40°C cannot form electromagnetic-wave absorbing sheets because the resins are too soft. Resin binders having a glass transition point higher than - 10°C are difficult to form sufficiently flexible and elastic electromagnetic-wave absorbing sheets because the resins become too hard. It is more preferable to use resin binders having a glass transition temperature (Tg) in a range from -15°C to -30°C.

### [Dispersant]

In the electromagnetic-wave absorbing composition of this embodiment, the magnetic iron oxide powder 1a such as epsilon iron oxide powder is used as the electromagnetic-wave absorbing material. The particle diameter of the magnetic iron oxide powder is small, and for example, the epsilon iron oxide powder is fine nanoparticle having a particle diameter of several nm to several tens of nm. It is important to favorably disperse the magnetic iron oxide powder in the electromagnetic-wave absorbing composition.

The strontium ferrite magnetic powder having an average particle diameter larger than that of the epsilon iron oxide powder also can form highly flexible and elastic electromagnetic-wave absorbing sheets when favorably dispersed in electromagnetic-wave absorbing sheets.

The use of the electromagnetic-wave absorbing composition of this embodiment as an electromagnetic-wave absorbing coating material is also taken into account, in addition to the use to form electromagnetic-wave absorbing sheets described above. The present inventors have found through studies that in such an electromagnetic-wave absorbing composition, the acid number of the dispersant is preferably 8 mg KOH/g or more and 46 mg KOH/g or less, and the amine number thereof is preferably 18 mg KOH/g or more and 44 mg KOH/g or less.

In a case where the magnetic iron oxide powder is dispersed in the binder resin, generally, it is necessary that an appropriate amount of the binder resin adsorbs to the surface of the magnetic iron oxide powder while the steric hindrance caused by free binder resin that does not adsorb to the surface of the magnetic iron oxide powder keeps a distance between the particles of the magnetic iron oxide powder to maintain the dispersed state of the particles.

Generally, the iron oxide magnetic powder used as an electromagnetic-wave absorbing material has a large number of alkaline active sites and a small number of acidic active sites. Meanwhile, the binder resin is preferably a binder resin having acidic groups and acid salts among the above binder resins, from the viewpoint of the production of the electromagnetic-wave absorbing sheets and the solubility into a solvent for use as the electromagnetic-wave absorbing coating material. However, when the binder resin having acidic groups and acid salts is used to disperse the magnetic iron oxide powder having a large number of alkaline active sites on its surface, a large amount of the binder resin adsorbs to the surface of the magnetic iron oxide powder due to too strong interaction between the two. The steric hindrance by free binder resin cannot be maintained, and the particles of the magnetic iron oxide powder approach each other and aggregate. If such an electromagnetic-wave absorbing composition with aggregation is used to produce electromagnetic-wave absorbing sheets, the sheets cannot be sufficiently flexible or elastic.

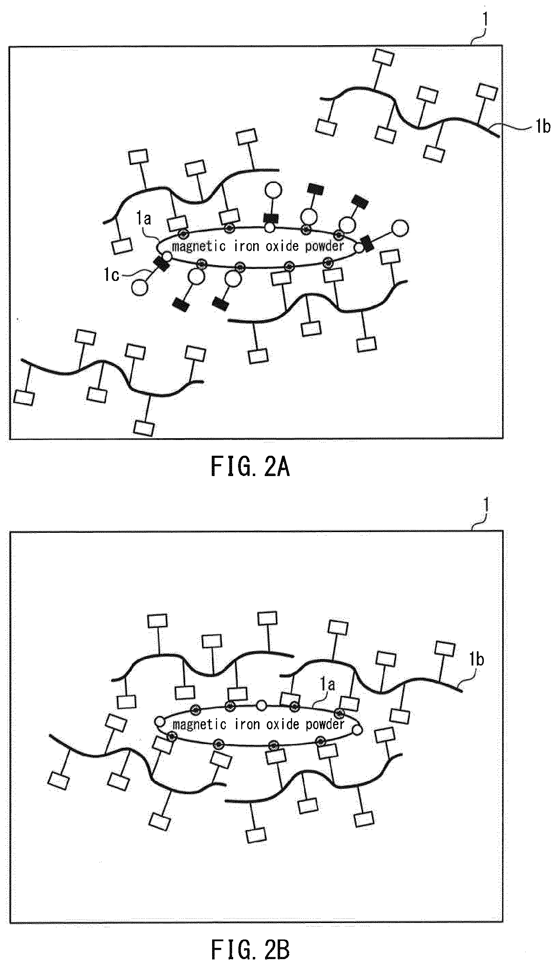

FIG. 2A and FIG. 2B are conceptual illustrations for explaining the function of the dispersant in the electromagnetic-wave absorbing composition of this embodiment. FIG. 2A illustrates a state in which the dispersant is contained together with the resin binder, and FIG. 2B illustrates a state in which the dispersant is not contained.

In the state of FIG. 2B in which the dispersant is not contained, the amount of a binder (polymer main chain) 1b having acidic groups and acid salts (white squares in FIG. 2B) that adsorbs to the magnetic iron oxide powder 1a having a large number of alkaline active sites (black circles in FIG. 2B) increases while the amount of the binder resin in a free state decreases, so that the steric hindrance by the free binder resin cannot be maintained, and the particles of the magnetic iron oxide powder 1a approach each other and aggregate.

In this case, if the amount of the binder resin to be used is increased to increase the amount of free binder resin, the amount of the iron oxide magnetic powder decreases relatively, and the electromagnetic-wave absorbing ability may deteriorate.

To cope with the above, by using a dispersant having an acid number of 8 mg KOH/g or more and 46 mg KOH/g or less and an amine number of 18 mg KOH/g or more and 44 mg KOH/g or less, it is possible to control the adsorption of the binder resin to the surface of the magnetic iron oxide powder. Consequently, the amount of the free binder resin increases without increasing the amount of the binder resin, and it is possible to provide a sufficiently flexible and elastic electromagnetic-wave absorbing sheet and an electromagnetic-wave absorbing coating material without deteriorating the electromagnetic-wave absorbing ability.

As illustrated in FIG. 2A, part of a dispersant 1c blocks the alkaline active sites (black circles in FIG. 2A) of the magnetic iron oxide powder 1a and reduces the interaction between the magnetic iron oxide powder 1a and the resin binder (polymer main chain) 1b, so that the amount of the binder 1b that adsorbs to the magnetic iron oxide powder 1a and the amount of the free binder 1b that does not adsorb to the magnetic iron oxide powder 1a are appropriately balanced. Consequently, the free resin binder 1b maintains the steric hindrance in the electromagnetic-wave absorbing composition, thereby reducing the aggregation and precipitation in the composition and maintaining the stability while enhancing the flexibility and elasticity in the electromagnetic-wave absorbing sheet formed of the electromagnetic-wave absorbing composition.

Specifically, the dispersant having the above acid number and amine number contains acidic functional groups such as carboxyl groups, which indicate the acid number, and alkaline functional groups such as amine groups and amide groups, which indicate the amine number, in one molecule. The acidic functional groups in the dispersant adsorb to the surface of the alkaline magnetic iron oxide powder. The alkaline functional groups in the dispersant interact with the binder resin, particularly with the binder resin having acidic groups and acid salts. This appropriately controls the adsorption of the binder resin to the magnetic iron oxide powder and as a result maintains the steric hindrance by the free resin binder. Thus, the aggregation and precipitation in the electromagnetic-wave absorbing composition can be reduced without increasing the amount of the resin binder, and the dispersibility improves.

The dispersant having an amine number in a range from 18 mg KOH/g to 44 mg KOH/g has favorable solubility in a solvent, and improves dispersibility by reducing the aggregation and precipitation in the electromagnetic-wave absorbing composition.

If the acid number of the dispersant to be used is less than 8 mg KOH/g, the interaction with the magnetic iron oxide powder becomes too weak to control the adsorption of the binder resin to the magnetic iron oxide powder. As a result, the steric hindrance by the free binder resin cannot the maintained, and the particles of the magnetic iron oxide powder cannot be favorably dispersed and aggregate in the electromagnetic-wave absorbing composition.

If the acid number is greater than 46 mg KOH/g, the dispersant excessively adsorbs to the magnetic iron oxide powder. The interaction between the binder resin and the magnetic iron oxide powder becomes weak, and the adsorption of the binder resin to the magnetic iron oxide powder excessively decreases. This causes the particles of the magnetic iron oxide powder to easily approach each other and aggregate in the electromagnetic-wave absorbing composition.

If the amine number is greater than 44 mg KOH/g, the interaction between the dispersant and the binder resin becomes strong. Meanwhile, the interaction between the binder resin and the magnetic iron oxide powder becomes weak, and the adsorption of the binder resin to the magnetic iron oxide powder excessively decreases. This prevents the magnetic iron oxide powder from being favorably dispersed, and aggregates the particles in the electromagnetic-wave absorbing composition.

If the amine number is less than 18 mg KOH/g, the interaction between the dispersant and the binder resin becomes weak, and the adsorption of the binder resin to the magnetic iron oxide powder decreases. This prevents the magnetic iron oxide powder from being favorably dispersed, and aggregates the particles in the electromagnetic-wave absorbing composition.

Thus, in the electromagnetic-wave absorbing composition of this embodiment, it is preferable to use a dispersant, specifically an amphoteric dispersant whose acid number and amine number both satisfy a predetermined requirement.

The acid number of the dispersant is more preferably 24 mg KOH/g or more and 46 mg KOH/g or less.

The acid number refers to mg of potassium hydroxide required to neutralize free fatty acid, resin acid, etc., contained in 1 g of a sample. The amine number refers to mg of potassium hydroxide equivalent to the acid required to neutralize 1 g of a sample.

### [Production method of electromagnetic-wave absorbing sheet]

Hereinafter, an exemplary method for producing an electromagnetic-wave absorbing sheet of this embodiment will be described.

The electromagnetic-wave absorbing sheet of this embodiment is produced by preparing a magnetic coating material using an electromagnetic-wave absorbing composition that includes at least magnetic iron oxide powder, a dispersant, and a resin binder, and applying the magnetic coating material in a predetermined thickness, followed by drying and calendering. Further, by using a solvent in the electromagnetic-wave absorbing composition, the aggregation and precipitation of the magnetic iron oxide powder reduces, and the dispersibility improves. Calendering is performed as needed. When the volume content of the magnetic iron oxide powder in a state where the magnetic coating material is dried is in a predetermined range, calendering is not needed.

First, a magnetic coating material is prepared.

A magnetic coating material is prepared by blending magnetic iron oxide powder (e.g., epsilon iron oxide powder), a dispersant whose acid number and amine number are within the above predetermined range, a resin binder, and a solvent.

Next, the magnetic coating material prepared is dispersed with a sand mill. By further blending a resin binder into the dispersed magnetic coating material and re-dispersing it with a sand mill, a more favorable electromagnetic-wave absorbing composition can be obtained.

A cross-linking agent may be blended into the dispersed magnetic coating material together with the resin binder for cross-linking. When the magnetic coating material is prepared by blending magnetic iron oxide powder, a dispersant, a resin binder, and a solvent, these materials may be mixed and kneaded in advance with a kneader and then dispersed with a sand mill.

An electromagnetic-wave absorbing sheet is produced using the thus prepared electromagnetic-wave absorbing composition.

In the production of the electromagnetic-wave absorbing sheet, the electromagnetic-wave absorbing composition is applied to the resin sheet 2 illustrated in FIG. 1. The resin sheet 2 may be, e.g., a 38 µm-thick polyethylene terephthalate (PET) sheet that has been subjected to a peeling treatment by silicone coating. The electromagnetic-wave absorbing composition is applied to the resin sheet 2 using an application method such as a table coater method or a bar coater method.

The wet electromagnetic-wave absorbing composition is dried and calendered to form an electromagnetic-wave absorbing sheet on the support. The thickness of the electromagnetic-wave absorbing sheet can be controlled by the coating thickness, the calendering conditions, and the like. The calendered electromagnetic-wave absorbing sheet 1 is peeled off from the resin sheet 2 to obtain an electromagnetic-wave absorbing sheet 1 having a desired thickness.

### [Various properties of electromagnetic-wave absorbing composition and electromagnetic-wave absorbing sheet]

The change in the various properties of the electromagnetic-wave absorbing composition and the electromagnetic-wave absorbing sheet depending on the acid number and the amine number of the dispersant was examined by comparing electromagnetic-wave absorbing compositions produced by the above production method and electromagnetic-wave absorbing sheets produced using the electromagnetic-wave absorbing compositions.

### <Example 1>

### {Magnetic coating material component 1}

First, materials below were mixed with a stirrer to prepare a magnetic coating material component 1.

| | |
|---|---|
| Magnetic iron oxide powder: Epsilon iron oxide magnetic powder | 100 parts |
| (average particle diameter: 30 nm) | |
| Dispersant: DISPERBYK-142 (trade name) | 15 parts |
| Acid number: 46 mg KOH/g, Amine number: 43 mg KOH/g | |
| Solvent: Methyl ethyl ketone/ Toluene | 95 parts |
| (= 1/1 mixed solvent) | |

### {Electromagnetic-wave absorbing composition}

The magnetic coating material component 1 was dispersed with a 2L disc sand mill using zirconia beads (diameter: 0.5 mm) (dispersing medium). While stirring the dispersed coating material with a stirrer, materials below were blended and dispersed under the same conditions as above to obtain an electromagnetic-wave absorbing composition.

| | |
|---|---|
| Magnetic coating material component 1 | 100 parts |
| Binder: Polyurethane binder | 46 parts |
| (VYLON UR 8700 (trade name), Tg: -22°C) | |
| Solvent (dilution): Methyl ethyl ketone/ Toluene | 120 parts |
| (= 1/1 mixed solvent) | |

### {Electromagnetic-wave absorbing sheet}

Subsequently, the electromagnetic-wave absorbing composition thus obtained was applied using a bar coater to a 38 µm-thick polyethylene terephthalate (PET) sheet that had been subjected to a peeling treatment by silicone coating. The wet composition was dried at 80°C for 1440 minutes to obtain a sheet having a thickness of 400 µm.

The sheet thus obtained was calendered at 80°C at a pressure of 150 kg/cm to produce an electromagnetic-wave absorbing sheet having a thickness of 300 µm.

DISPERBYK-142 used as the dispersant in the above is a high molecular weight wet dispersant for a solvent-based coating material manufactured by BYK Japan KK. VYLON UR 8700 used as the resin binder is a polyester urethane resin manufactured by TOYOBO CO., LTD.

Electromagnetic-wave absorbing sheets of Examples 2-4 and electromagnetic-wave absorbing sheets of Comparative Examples 1-4 were produced in the same manner as in the electromagnetic-wave absorbing sheet of Example 1 except for the dispersant. Both of the acid number and the amine number of the dispersants of Examples 2-4 were within the above numerical range described in this embodiment, whereas at least one of the acid number and the amine number of the dispersants of Comparative Examples 1-4 was not within the above numerical range. The following are the dispersants used to produce the electromagnetic-wave absorbing sheets and the acid number and the amine number of the dispersants.

### <Example 2>

Dispersant: ANTI-TERRA-U (trade name)
Acid number: 24 mg KOH/g, Amine number: 19 mg KOH/g

### <Example 3>

Dispersant: DISPERBYK-2013 (trade name)
Acid number: 8 mg KOH/g, Amine number: 18 mg KOH/g

### <Example 4>

Dispersant: BYK-9076 (trade name)
Acid number: 38 mg KOH/g, Amine number: 44 mg KOH/g

### <Comparative Example 1>

Dispersant: DISPERBYK-140 (trade name)
Acid number: 73 mg KOH/g, Amine number: 76 mg KOH/g

### <Comparative Example 2>

Dispersant: DISPERBYK-145 (trade name)
Acid number: 76 mg KOH/g, Amine number: 71 mg KOH/g

### <Comparative Example 3>

Dispersant: DISPERBYK-2155 (trade name)
Acid number: 0 mg KOH/g, Amine number: 48 mg KOH/g

### <Comparative Example 4>

Dispersant: DISPERBYK-185 (trade name)
Acid number: 0 mg KOH/g, Amine number: 17 mg KOH/g

All of the dispersants used in Examples 2-4 and Comparative Examples 1-4 are high molecular weight wet dispersants for a solvent-based coating material manufactured by BYK Japan KK, as with the dispersant used in Example 1.

Further, an electromagnetic-wave absorbing sheet of Example 5 was produced using an electromagnetic-wave absorbing composition 2 including strontium ferrite as the magnetic iron oxide powder.

### <Example 5>

### {Magnetic coating material component 2}

A magnetic coating material component 2 was prepared in the same manner as in Example 1 except that strontium ferrite magnetic powder was used as the magnetic iron oxide powder.

First, materials below were mixed with a stirrer to prepare a magnetic coating material component 2.

| | |
|---|---|
| Magnetic iron oxide powder: Strontium ferrite magnetic powder | 100 parts |
| (average particle diameter: 5 µm) | |
| Dispersant: DISPERBYK-142 (trade name) | 15 parts |
| Acid number: 46 mg KOH/g, Amine number: 43 mg KOH/g | |
| Solvent: Methyl ethyl ketone/ Toluene | 95 parts |
| (= 1/1 mixed solvent) | |

### {Electromagnetic-wave absorbing composition 2}

The magnetic coating material component 2 was dispersed with a 2L disc sand mill using zirconia beads (diameter: 0.5 mm) (dispersing medium). While stirring the dispersed coating material with a stirrer, materials below were blended and dispersed under the same conditions as above to obtain an electromagnetic-wave absorbing composition.

| | |
|---|---|
| Magnetic coating material component 2 | 100 parts |
| Binder: Polyurethane binder | 46 parts |
| (VYLON UR 8700 (trade name), Tg: -22°C) | |
| Solvent (dilution): Methyl ethyl ketone/ Toluene | 120 parts |
| (= 1/1 mixed solvent) | |

### {Electromagnetic-wave absorbing sheet 2}

Subsequently, the electromagnetic-wave absorbing composition thus obtained was applied using a bar coater to a 38 µm-thick polyethylene terephthalate (PET) sheet that had been subjected to a peeling treatment by silicone coating, followed by drying of the wet composition at 80°C for 1440 minutes to obtain a sheet having a thickness of 1400 µm. The sheet thus obtained was calendered at 80°C at a pressure of 150 kg/cm to produce an electromagnetic-wave absorbing sheet having a thickness of 1362 µm.

Further, electromagnetic-wave absorbing sheets of Example 6 and Example 7 were produced using binders having a glass transition temperature different from that of the binder of the electromagnetic-wave absorbing sheet of Example 1.

### <Example 6>

| | |
|---|---|
| Magnetic coating material component 1 | 100 parts |
| Binder: Polyester binder | 46 parts |
| (VYLON 55SS (trade name), Tg: -15°C) | |
| Solvent (dilution): Methyl ethyl ketone/ Toluene | 127 parts |
| (= 1/1 mixed solvent) | |

### <Example 7>

| | |
|---|---|
| Magnetic coating material component 1 | 100 parts |
| Binder: Polyurethane binder | 44 parts |
| (VYLON UR 6100 (trade name), Tg: -30°C) | |
| Solvent (dilution): Methyl ethyl ketone/ Toluene | 118 parts |
| (= 1/1 mixed solvent) | |

VYLON 55SS used as the resin binder in Example 6 is an amorphous polyester resin manufactured by TOYOBO CO., LTD. VYLON UR 6100 used as the resin binder in Example 7 is a polyester-based urethane resin manufactured by TOYOBO CO., LTD.

### [Average particle diameter]

In the average particle diameter measurement, measurement samples having a solid component concentration of 52% by weight were prepared by stirring {Magnetic coating material component 1} and {Magnetic coating material component 2} in Examples and Comparative Examples with a stirrer.

A fiber-optics particle analyzer FPAR-1000 (trade name) manufactured by OTSUKA ELECTRONICS Co., LTD., a ND filter (10%), a dilution solvent (MEK), and a dilution probe were used in the measurement.

As measurement results, samples having an average particle diameter of 150 nm or less were judged to be sufficiently dispersed and evaluated as "good", and samples having an average particle diameter of more than 150 nm were judged to be not sufficiently dispersed and evaluated as "poor".

### [Reflection density]

In the reflection density measurement, films as measurement samples were prepared by applying the {Electromagnetic-wave absorbing compositions} in Examples and Comparative Examples on a PET film with an applicator in a wet thickness of 60 µm, followed by natural drying.

A reflection densitometer Macbeth RD-920 (product name) manufactured by SAKATAINX ENG. CO., LTD., was used in the measurement.

As measurement results, samples having a reflection density of 1.9 or more were evaluated as "good", and samples having a reflection density of less than 1.9 were evaluated as "poor".

### [Flexibility]

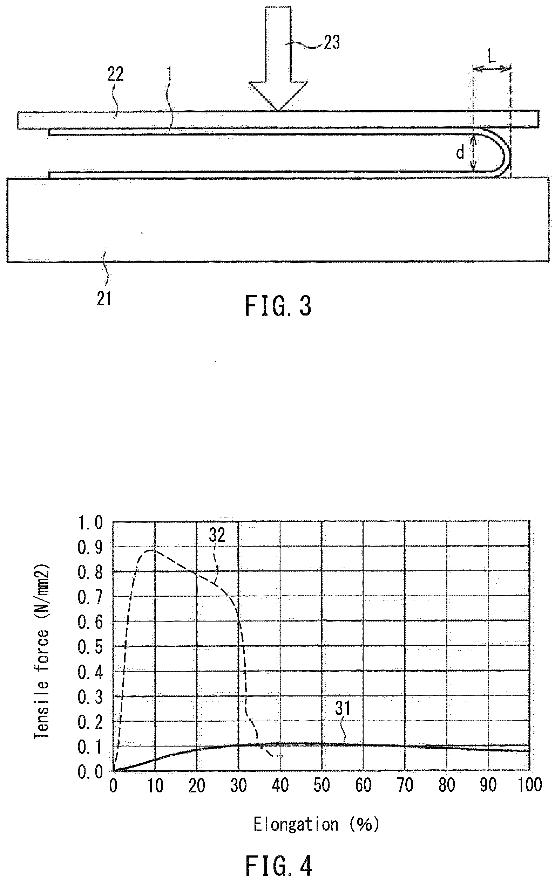

FIG. 3 is a view illustrating a method for evaluating the flexibility of the electromagnetic-wave absorbing sheet.

{Electromagnetic-wave absorbing sheets} of Examples and Comparative Examples, each in the form of a ribbon with a length of 100 mm and a width of 20 mm, were prepared for the measurement. As illustrated in FIG. 3, the ribbon-like electromagnetic-wave absorbing sheet 1 was folded lengthwise in the middle so that both ends in the longitudinal direction of the sheet overlap each other. Then, an external force required to maintain this state was determined. Table 1 below indicates the thicknesses of the electromagnetic-wave absorbing sheets of Examples and Comparative Examples.

Specifically, the electromagnetic-wave absorbing sheet 1 to be measured was placed on a measurement stand 21 of an electronic balance, and a self-weight of the electromagnetic-wave absorbing sheet was measured while no external force was applied. Next, a weight added to the electronic balance was measured when an external force 23 was applied to deform the electromagnetic-wave absorbing sheet, as illustrated in FIG. 3. The self-weight of the electromagnetic-wave absorbing sheet was subtracted from the measurement result to find the applied weight that was required to maintain the folded state of the electromagnetic-wave absorbing sheet.

A plate member 22 was placed on the upper side of the electromagnetic-wave absorbing sheet 1 so that the electromagnetic-wave absorbing sheet 1 would remain in the predetermined folded state, as illustrated in FIG. 3. An external force was applied vertically downward to the plate member 22, as indicated by an white arrow 23 in FIG. 3. Then, the magnitude of the external force 23 was measured as a weight when a distance d between the inner surfaces of the folded sheet at a position spaced L (10 mm) from the outer edge of the bent portion of the electromagnetic-wave absorbing sheet 1 was 10 mm (d = 10 mm). The measured weight was divided by a cross-sectional area D (mm²) of the electromagnetic-wave absorbing sheet to give a flexibility evaluation value F (g/mm²).

In Examples and Comparative Examples, electromagnetic-wave absorbing sheets produced without adding a dispersant were also prepared as references. F0 represents a flexibility evaluation value of the reference, and F1 represents a flexibility evaluation value of the electromagnetic-wave absorbing sheet produced by adding a dispersant. An effect value of dispersant (%) is expressed by Formula (F0-F1) / F0 × 100.

The effect value of dispersant (%) indicates the degree of improvement in flexibility by use of dispersant, with respect to electromagnetic-wave absorbing sheets produced without using a dispersant. In electromagnetic-wave absorbing sheets such as that described in this embodiment that are produced by mixing fine metal powder (magnetic iron oxide powder) into a resin binder, if the volume content of the magnetic iron oxide powder is the same, electromagnetic-wave absorbing sheets having a higher dispersion degree of the magnetic iron oxide powder have higher flexibility. The above measurement method can measure the dispersion degree of the magnetic iron oxide powder purely by a dispersant.

As indicated in Table 1 below, the electromagnetic-wave absorbing sheets of Examples 1-7, which were produced using the dispersants whose acid number and amine number were within the range specified in the present invention, resulted in the flexibility evaluation value of about 50%, that is, the external force required to fold the electromagnetic-wave absorbing sheet in a predetermined shape was about one half of the case of not using a dispersant. This indicates that the dispersant softened the electromagnetic-wave absorbing sheets.

The electromagnetic-wave absorbing sheets of Comparative Examples 1-4, which were produced using the dispersants whose acid number and amine number were not within the range specified in the present invention, resulted in low flexibility evaluation values and thus were brittle and tended to break. The addition of the dispersants did not contribute to the improvement in the flexibility of the electromagnetic-wave absorbing sheets. The above confirmed that the flexibility of the electromagnetic-wave absorbing sheets was not sufficiently improved by the dispersants whose acid number and amine number were not within the range specified in the present application.

### [Elongation]

As to the elongation (elasticity) of the electromagnetic-wave absorbing sheets, measurement samples were prepared by forming {Electromagnetic-wave absorbing sheets} of Examples and Comparative Examples into ribbon-shapes with a length of 30 mm and a width of 20 mm.

The measurement was performed using a tensile tester TRE-1kN manufactured by MinebeaMitsumi Inc., at a temperature of 23°C and a humidity of 50% RH. Each measurement sample was stretched up to 100 mm at a stretching speed of 10 mm/min.

The elongation amount of each of the electromagnetic-wave absorbing sheets of Examples and Comparative Examples in a state where the maximum tensile force (N/mm²) was applied thereto in the tensile test, is expressed in percentage (%) with respect to the length 30 mm before the tensile test.

FIG. 4 shows the results of the tensile test of the electromagnetic-wave absorbing sheet of Example 1 and the electromagnetic-wave absorbing sheet of Comparative Example 1.

The electromagnetic-wave absorbing sheet of Example 1, indicated by a solid line 31 in FIG. 4, kept stretching with a tensile force of about 0.1 N/mm², and the elasticity of the sheet was stable even when the elongation amount became 100%, i.e., the total length (originally 30 mm) became 60 mm. The maximum tensile force of the electromagnetic-wave absorbing sheet of Example 1 was 0.11 N/mm² at the elongation amount of 41%.

Meanwhile, the electromagnetic-wave absorbing sheet of Comparative Example 1 including the dispersant whose acid number and amine number were not within the range specified in the present invention required a large tensile force to stretch, and plastically deformed at a tensile force of about 0.9 N/mm², as indicated by a dotted line 32 in FIG. 4. The elongation amount of the sheet at this time remained about 10%.

The above indicates that the electromagnetic-wave absorbing sheet produced using the electromagnetic-wave absorbing composition including the dispersant whose acid number and amine number were within the predetermined range of the present invention exhibited high elasticity.

### [Precipitation]

{Electromagnetic-wave absorbing compositions} of Examples and Comparative Examples were each placed in a 9 cc screw-capped bottle and left for 24 hours.

{Electromagnetic-wave absorbing compositions} after standing were observed visually to check the presence or absence of precipitation, and compositions with no precipitation were evaluated as "good", and compositions with precipitation were evaluated as "poor".

### [Evaluation results]

Table 1 below summarizes the acid number and the amine number of the dispersants used in Examples 1-4 and Comparative Examples 1-4 as well as the evaluation results of [Average particle diameter], [Reflection density], [Flexibility], [Elongation] and [Precipitation] .

**[Table 1]**

| | | Ex. 1 | Ex. 2 | Ex. 3 | Ex. 4 | Ex. 5 | Ex. 6 | Ex. 7 | Comp. Ex. 1 | Comp. Ex. 2 | Comp. Ex. 3 | Comp Ex. 4 |
|---|---|---|---|---|---|---|---|---|---|---|---|---|
| Dispersant | Acid number (mg KOH/g) | 46 | 24 | 8 | 38 | 46 | 46 | 46 | 73 | 76 | 0 | 0 |
| | Amine number (mg KOH/g) | 43 | 19 | 18 | 44 | 43 | 43 | 43 | 76 | 71 | 48 | 17 |
| Composition | Average particle diameter | good | good | good | good | good | good | good | poor | poor | poor | poor |
| | Precipitation | good | good | good | good | good | good | good | poor | poor | poor | poor |
| | Reflection density | good | good | good | good | good | good | good | poor | poor | poor | poor |
| Sheet | Flexibility (%) | 56 | 50 | 48 | 52 | 50 | 54 | 58 | 30 | 32 | 2 | 3 |
| | Elongation (%) | 41 | 38 | 35 | 40 | 39 | 41 | 45 | 10 | 9 | 3 | 5 |
| | Thickness (mm) | 1.351 | 1.265 | 1.352 | 1.029 | 1.362 | 1.389 | 1.346 | 1.052 | 1.029 | 1.050 | 1.258 |

| | | | | | | | | | | | | |
|---|---|---|---|---|---|---|---|---|---|---|---|---|
| * Ex.: Example, Comp. Ex.: Comparative Example | | | | | | | | | | | | |

As indicated in Table 1, when the dispersant having an acid number of 8 mg KOH/g or more and 46 mg KOH/g or less and an amine number of 18 mg KOH/g or more and 44 mg KOH/g or less was used, epsilon iron oxide or strontium ferrite magnetic iron as the magnetic iron oxide was favorably dispersed, and high dispersion was obtained both as the magnetic coating material and the electromagnetic-wave absorbing composition. Further, the electromagnetic-wave absorbing sheets produced using the electromagnetic-wave absorbing compositions including the dispersants whose acid number and amine number were within the predetermined range of the present invention resulted in a high flexibility evaluation value of 40% or more and an elongation amount (elasticity) of 30% of more, which are both favorable properties.

Further, precipitation was not found after standing for 24 hours in the electromagnetic-wave absorbing compositions of Examples including the dispersant whose acid number and amine number were within the predetermined range of the present invention, whereas precipitation was confirmed after standing for 24 hours in all of the electromagnetic-wave absorbing compositions of Comparative Examples.

In order to use the electromagnetic-wave absorbing composition as the electromagnetic-wave absorbing coating material, it is necessary that the magnetic iron oxide powder as the electromagnetic-wave absorbing material maintains the favorably dispersed state without precipitating for a certain period of time from a time when the coating material is prepared to a time when it is actually applied to an object. It was confirmed also in this regard that by producing the electromagnetic-wave absorbing composition using the dispersant having the acid number and amine number specified in the present application, high practicality is achieved.

In the flexibility confirmation test, the reduction degree of the external force in the case of including a dispersant was measured as a flexibility evaluation value, using the external force in the case of not including a dispersant as a reference. At this time, a relationship between the thickness of the electromagnetic wave absorbing sheet and the electromagnetic-wave absorbing properties in the case of including a dispersant and in the case of not including a dispersant was also confirmed.

The electromagnetic-wave absorbing properties were determined in accordance with a free space method. Specifically, a millimeter-wave network analyzer N5250C (trade name) manufactured by Agilent Technologies Japan, Ltd., was used to irradiate an electromagnetic-wave absorbing sheet with input waves (millimeter-waves) having a predetermined frequency from a transmission antenna via a dielectric lens using one port and to receive electromagnetic waves passing through the sheet by a reception antenna that is disposed on the back side of the sheet. The intensity of the irradiated electromagnetic waves and the intensity of the transmitted electromagnetic waves were compared to determine an electromagnetic-wave attenuation degree (dB).

For example, in the comparison between the electromagnetic-wave absorbing sheet of Example 1 and the electromagnetic-wave absorbing sheet serving as a reference of Example 1 not including a dispersant, the electromagnetic-wave absorbing properties of the electromagnetic-wave absorbing sheet of Example 1 resulted in 20 dB, and the electromagnetic-wave absorbing properties of the electromagnetic-wave absorbing sheet as a reference resulted in 21 dB when the thicknesses of the sheets were both converted to 4.0 mm. This confirmed that the presence or absence of the dispersant hardly changes the electromagnetic-wave absorbing properties when the thicknesses of the electromagnetic-wave absorbing layers are converted to the same thickness.

As to [Precipitation] in the evaluation results, the present inventors further examined a degree of maintaining the dispersing effect by the dispersant whose acid number and amine number were within the range specified in the present application.

Specifically, the electromagnetic-wave absorbing composition of Example 1 was placed in a 9 cc screw-capped bottle and left similarly to the above, and the average particle diameter of the epsilon iron oxide powder after a lapse of a predetermined time was measured.

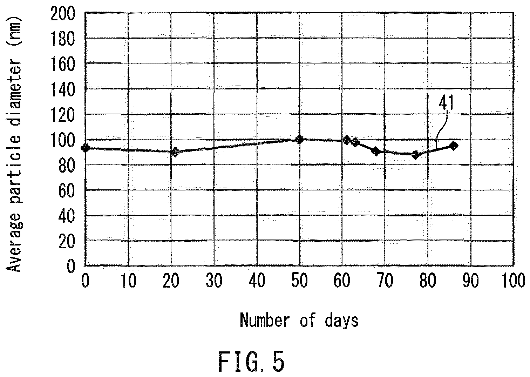

FIG. 5 illustrates a relationship between the standing time and the average particle diameter of the epsilon iron oxide powder.

An indictor 41 in FIG. 5 shows that, in the electromagnetic-wave absorbing composition of Example 1, the average particle diameter of the epsilon iron oxide powder remained substantially constant between 90 nm and 100 nm for at least 86 hours from the start of standing. Meanwhile, in the electromagnetic-wave absorbing composition of Comparative Example 1, the particles precipitated due to aggregation after a lapse of 24 hours as described above, and the average particle diameter could not be measured.

This confirmed that the dispersant whose acid number and amine number are within the range specified in the present application can maintain the dispersion function of preventing the magnetic iron oxide powder in the electromagnetic-wave absorbing composition from aggregating for a long period of time.

The above result reconfirmed that the electromagnetic-wave absorbing composition disclosed in the present application is highly practical also as the electromagnetic-wave absorbing coating material.

As explained above, it was confirmed that the electromagnetic-wave absorbing composition of this embodiment can maintain high dispersibility of the magnetic iron oxide powder (electromagnetic-wave absorbing material) for a long period of time, using the dispersant whose acid number and amine number are within the specified range.

By producing electromagnetic-wave absorbing sheets using the electromagnetic-wave absorbing composition of this embodiment, it is possible to obtain highly flexible and elastic electromagnetic-wave absorbing sheets. Further, the electromagnetic-wave absorbing composition of this embodiment itself can be favorably used as the electromagnetic-wave absorbing coating material.

The reason for the above is considered as below. The low molecular-weight amphoteric dispersant enters between particles of the magnetic iron oxide powder to untie the particles by the interaction between the amphoteric dispersant and the alkaline active sites of the magnetic iron oxide powder. Further, due to the interaction with the resin binder having acidic groups and acid salts, an appropriate amount of free resin binder causes steric hindrance, which maintains the dispersibility of the magnetic iron oxide and forms a flexible and elastic film.

The above embodiment exemplifies the electromagnetic-wave absorbing sheet configured only by the electromagnetic-wave absorbing layer that absorbs electromagnetic waves and that is formed of the electromagnetic-wave absorbing composition. However, in the invention disclosed in the present application, the electromagnetic wave absorbing sheet can be configured also as a laminate of an electromagnetic-wave absorbing layer and a resin layer as a base within a range that does not impair the flexibility and elasticity of the electromagnetic-wave absorbing layer. This configuration improves the durability and the ease of handling of the electromagnetic-wave absorbing sheet. Further, the electromagnetic-wave absorbing sheet may be a laminate of an electromagnetic-wave absorbing layer and an adhesive layer, so that it can adhere to an arrangement location with ease.

Further, the electromagnetic-wave absorbing sheet may be configured as a reflection-type electromagnetic-wave absorbing sheet that reflects electromagnetic waves without deteriorating the flexibility and elasticity of the electromagnetic-wave absorbing layer, by laminating with a reflective layer having a certain level of reflection properties.

### Industrial Applicability

The electromagnetic-wave absorbing composition disclosed in the present application and the electromagnetic-wave absorbing sheet produced using the electromagnetic-wave absorbing composition are useful as a coating material and a sheet that absorb electromagnetic waves in a high frequency band in or above the millimeter-wave band.

### Description of Reference Numerals

- 1: Electromagnetic-wave absorbing sheet
- 1a: Epsilon iron oxide (magnetic iron oxide powder)
- 1b: Binder
- 1c: Dispersant

## Claims

1. An electromagnetic-wave absorbing composition, comprising:
magnetic iron oxide powder having a magnetic resonance frequency;
a binder resin; and
a dispersant,
wherein the dispersant has an acid number of 8 mg KOH/g or more and 46 mg KOH/g or less and an amine number of 18 mg KOH/g or more and 44 mg KOH/g or less.

2. The electromagnetic-wave absorbing composition according to claim 1, wherein a glass transition temperature (Tg) of the binder resin is -10°C to -40°C.

3. The electromagnetic-wave absorbing composition according to claim 1 or 2, wherein the magnetic iron oxide powder is at least one of epsilon iron oxide and strontium ferrite.

4. The electromagnetic-wave absorbing composition according to claim 3, wherein part of a Fe site of the epsilon iron oxide is substituted with a trivalent metal atom.

5. An electromagnetic-wave absorbing sheet, comprising an electromagnetic-wave absorbing layer comprising the electromagnetic-wave absorbing composition according to any of claims 1 to 4.

## Amended claims

### Amended claims under Art. 19.1 PCT

1. An electromagnetic-wave absorbing composition for use as an electromagnetic-wave absorbing member that absorbs electromagnetic waves of frequencies in or above a millimeter-wave band, comprising:
magnetic iron oxide powder having a magnetic resonance frequency;
a binder resin; and
a dispersant,
wherein the dispersant has an acid number of 8 mg KOH/g or more and 46 mg KOH/g or less and an amine number of 18 mg KOH/g or more and 44 mg KOH/g or less.

2. The electromagnetic-wave absorbing composition according to claim 1, wherein a glass transition temperature (Tg) of the binder resin is -10°C to -40°C.

3. The electromagnetic-wave absorbing composition according to claim 1 or 2, wherein the magnetic iron oxide powder is at least one of epsilon iron oxide and strontium ferrite.

4. The electromagnetic-wave absorbing composition according to claim 3, wherein part of a Fe site of the epsilon iron oxide is substituted with a trivalent metal atom.

5. An electromagnetic-wave absorbing sheet, comprising an electromagnetic-wave absorbing layer comprising the electromagnetic-wave absorbing composition according to any of claims 1 to 4.

6. The electromagnetic-wave absorbing sheet according to claim 5, wherein an effect value of the dispersant (%) determined by Formula (F0-F1) / F0 × 100 is 48% to 58%, where F0 represents a flexibility evaluation value in a case where the electromagnetic-wave absorbing sheet does not include the dispersant, and F1 represents a flexibility evaluation value in a case where the electromagnetic-wave absorbing sheet includes the dispersant.

7. The electromagnetic-wave absorbing sheet according to claim 5 or 6, wherein an elongation amount of the electromagnetic-wave absorbing sheet in a state where a maximum tensile force is applied to the electromagnetic-wave absorbing sheet in a tensile test is 35% to 45%.
